# FASCICULE DE BREVET EUROPEEN

(11) **EP 3 622 478 B1**
(45) Date de publication et mention de la délivrance du brevet: **17.11.2021**
(21) Numéro de dépôt: 18723536.1
(22) Date de dépôt: 11.05.2018
(51) Int. Cl.: G06T 7/11, G06T 7/12

(54) **METHODE DE SEGMENTATION D'UNE IMAGE TRIDIMENSIONNELLE POUR LA GENERATION D'UN MODELE DE PAROI DU MYOCARDE POUR LA DETECTION D'AU MOINS UNE ZONE DE CIRCULATION ELECTRIQUE SINGULIERE**
VERFAHREN ZUR SEGMENTIERUNG EINES DREIDIMENSIONALEN BILDES ZUR ERZEUGUNG EINES MODELLS EINER MYOKARDIALEN WAND ZUM NACHWEIS VON MINDESTENS EINER EINZIGEN ZONE MIT ELEKTRISCHER ZIRKULATION
METHOD OF SEGMENTATION OF A THREE-DIMENSIONAL IMAGE FOR GENERATING A MODEL OF A MYOCARDIAL WALL FOR THE DETECTION OF AT LEAST ONE SINGULAR ZONE OF ELECTRICAL CIRCULATION

(30) Priorité: 10.05.2017 FR 1754107
(43) Date de publication de la demande: 18.03.2020
(73) Titulaire: Université de Bordeaux, 33000 Bordeaux (FR); Centre Hospitalier Universitaire de Bordeaux, 33404 Talence Cedex (FR); Fondation Universite Bordeaux, 33000 Bordeaux (FR); Institut National de la Santé et de la Recherche Médicale, 75013 Paris (FR); Institut National de Recherche en Informatique et en Automatique, 78150 Le Chesnay (FR)
(72) Inventeur: COCHET, Hubert, 33000 Bordeaux (FR); SERMESANT, Maxime, 06370 Mouans Sartoux (FR); JAIS, Pierre, 33160 St Médard en Jalles (FR)
(74) Mandataire: Cabinet Camus Lebkiri
(86) Numéro de dépôt international: PCT/EP2018/062258
(87) Numéro de publication internationale: WO 2018/206796

(56) Documents cités:
- WO-A1-2015/086368
- WO-A1-2015/165978
- WO-A1-2015/168792
- US-A- 5 601 084
- US-A1- 2004 247 165
- US-A1- 2013 057 548
- I-CHEN TSAI ET AL: "Left ventricular myocardium segmentation on arterial phase of multi-detector row computed tomography", COMPUTERIZED MEDICAL IMAGING AND GRAPHICS, PERGAMON PRESS, NEW YORK, NY, US, vol. 36, no. 1, 18 mars 2011 (2011-03-18), pages 25-37, XP028340976, ISSN: 0895-6111, DOI: 10.1016/J.COMPMEDIMAG.2011.03.003 [extrait le 2011-03-28]

## Description

### DOMAINE

Le domaine de l'invention concerne les méthodes de traitement d'images et de simulation pour déterminer des caractéristiques électriques particulières d'un modèle de myocarde. Plus particulièrement, le domaine de l'invention concerne les méthodes de segmentation d'une paroi du myocarde afin d'isoler et caractériser des phénomènes électriques singuliers à l'intérieur d'un myocarde modélisé.

### ETAT DE L'ART

Actuellement, il existe des procédés d'exploration permettant de déterminer une activité électrique à la surface du myocarde. L'étude de cette activité électrique requière le plus généralement l'analyse de cartes acquises de manière invasive, à l'aide de cathéters adaptés, localisés en 3D. L'analyse de l'activité électrique au sein du myocarde est particulièrement importante pour la détection de zones électriquement anormales responsables d'arythmies potentiellement létales. Ces zones peuvent par la suite faire l'objet d'un traitement ciblé.

Toutefois, l'identification des zones critiques responsables des arythmies nécessite de réaliser des interventions longues et risquées. Par ailleurs, la définition des cibles reste très imparfaite, l'arythmie elle-même étant souvent non observée. En effet, elle est soit impossible à reproduire pendant l'intervention, soit trop mal tolérée par le patient pour laisser le temps au médecin d'en effectuer une cartographie avec ses cathéters. L'efficacité de ces interventions est donc limitée et les patients présentent fréquemment des récidives.

Avant ces interventions, il est possible de réaliser des examens d'imagerie tridimensionnelle afin d'analyser la structure du muscle. Ces examens non invasifs peuvent renseigner sur la localisation des cicatrices en cause dans les arythmies.

Les documents US 2013/057548 et US 2004/247165 décrivent des exemples de telles méthodes.

Il n'existe en revanche pas de méthode permettant de modéliser la circulation électrique au sein de certains zones d'intérêt, par exemple de zones comportant une cicatrice, afin d'identifier et catégoriser des typologies de circuits électriques.

Il existe un besoin de connaitre les possibles circuits électriques et leur typologie dans certaines zones d'intérêts afin de comprendre et modéliser la propagation électrique dans le myocarde.

Au total, l'homme de l'art dispose de méthodes invasives, par exemple au moyen de cathéters, et non-invasives, par exemple grâce à l'imagerie, lui permettant de localiser les cicatrices. Cependant, ces méthodes ne permettent pas d'identifier de manière fiable des sites dont l'activité électrique est représentative de singularités spécifiques.

### RESUME DE L'INVENTION

Le procédé de l'invention permet de résoudre les problèmes précités. En effet, le procédé de l'invention permet de réaliser une segmentation de la paroi du cœur afin de générer un modèle permettant d'isoler ou de visualiser des comportements électriques singuliers ou atypiques au sein du myocarde.

Selon un aspect, l'invention concerne une méthode de segmentation d'une épaisseur du myocarde issue d'une image tridimensionnelle pour la génération d'un modèle de paroi du myocarde afin de détecter au moins une circulation électrique singulière, caractérisée en ce qu'elle comprend :
- Un enregistrement d'une image tridimensionnelle d'une paroi du myocarde, ladite paroi délimitant au moins une cavité du cœur ;
- Une segmentation d'une partie continue de la paroi en au moins un premier volume comportant une épaisseur inférieure à un premier seuil prédéfini, ledit premier seuil étant inférieur à un seuil d'intérêt et un second volume d'une partie continue de la paroi comportant une épaisseur supérieure au premier seuil et inférieur au seuil d'intérêt;
- Une génération d'un modèle de paroi du myocarde dans laquelle la partie continue de la paroi du myocarde est modélisée selon au moins deux volumes, ledit modèle de paroi permettant de modéliser au moins un gradient électrique entre lesdits volumes afin de localiser au moins une zone de circulation électrique singulière.

Un avantage est de permettre une modélisation de la paroi du myocarde permettant de détecter/identifier des zones singulières géométriquement ou électriquement. On parle d'isthmes dans un cas et de circuits de propagation électrique singuliers dans l'autre cas. Un intérêt de l'invention est d'identifier des typologies de zones singulières pour comprendre les mécanismes électriques susceptibles d'induire des effets ou non dans la propagation d'une zone d'intérêt du myocarde. Un autre avantage est de permettre de réaliser des simulateurs fiables pour modéliser l'activité électrique du cœur.

Selon différents cas de figures, la modélisation et plus particulièrement la segmentation de la paroi peuvent être réalisées selon différents modes de réalisation présentant divers avantages : simplicité de l'algorithme, finesse de la segmentation en définissant une pluralité de couches tridimensionnelles ou encore selon si la segmentation met en œuvre une attribution de valeurs d'un paramètre électro-physiologique ou non. Selon les effets techniques souhaités, l'une des segmentations peut être choisie.

Selon un mode de réalisation, la méthode comprend une segmentation préalable à la première segmentation d'au moins une région d'intérêt formant une partie continue de la paroi du myocarde et délimitée selon un critère d'épaisseur de paroi, l'épaisseur de la région d'intérêt étant inférieure au seuil d'épaisseur maximal.

Selon un mode de réalisation, la segmentation d'une partie de la paroi comporte une segmentation des volumes en au moins trois types d'épaisseurs dont une première épaisseur est inférieure à un premier seuil prédéfini, ledit premier seuil étant inférieur à un seuil d'intérêt, une troisième épaisseur est supérieure à un second seuil prédéfini, ledit second seuil étant inférieur à un seuil d'intérêt, et supérieur au premier seuil, et une seconde épaisseur comprise entre le premier seuil et le second seuil, les volumes ainsi segmentés formant des couches tridimensionnelles de différentes épaisseurs.

Selon un mode de réalisation, la segmentation des volumes est réalisée selon une pluralité d'épaisseurs, une première épaisseur étant inférieure à un premier seuil prédéfini, ledit premier seuil étant inférieur à un seuil d'intérêt, une P^{ème} épaisseur comportant :
▪ une épaisseur supérieure à un (P-1)^{ème} seuil prédéfini, ledit (P-1)^{ème} seuil étant inférieur à un seuil d'intérêt (Si), et
▪ une épaisseur inférieure à un P^{ème} seuil prédéfini, ledit P^{ème} seuil étant inférieur à un seuil d'intérêt (Si),
les volumes ainsi segmentés formant des couches tridimensionnelles de différentes épaisseurs.

Selon un mode de réalisation, chaque volume segmenté comporte des dimensions correspondantes à une surface représentant la surface d'un pixel ou d'un voxel et une épaisseur correspondant à celle de la paroi au pixel/voxel considérée, la partie continue de la paroi correspondant à un ensemble d'au moins deux pixels/voxels formant une portion continue de l'image, l'ensemble des volumes segmentés de même épaisseur formant chacun une couche tridimensionnelle.

Selon un mode de réalisation, lors de la segmentation ou la génération du modèle de paroi du myocarde, la méthode comporte une attribution à chacun des volumes segmentés d'une valeur donnée d'au moins un paramètre électro-physiologique.

Selon un mode de réalisation, la segmentation d'une partie de la paroi du myocarde est réalisée conjointement à une attribution de valeurs d'au moins un paramètre électro-physiologique, l'attribution étant effectuée selon une fonction associant à chaque valeur d'épaisseur une valeur d'un paramètre électro-physiologique.

Selon un mode de réalisation, l'attribution de valeurs d'au moins un paramètre électro-physiologique est réalisée pixel/voxel par pixel/voxel en considérant une partie continue de la paroi. Dans ce cas, le modèle de paroi comporte des ensembles de volumes segmentés de même épaisseur et étant associés chacun à une valeur d'au moins un paramètre électro-physiologique, lesdits ensembles formant chacun une couche tridimensionnelle.

Selon un mode de réalisation, au moins un paramètre électro-physiologique est :
▪ une vitesse de propagation de courant comprise dans la gamme : [Om/s ; 4m/s] ou ;
▪ au moins une donnée caractérisant le potentiel d'action ou ;
▪ au moins une impédance électrique ou une résistance électrique locale de la paroi du myocarde modélisée.

Selon un mode de réalisation, une pluralité de paramètres électrophysiologiques peuvent être pris en compte. Un avantage est de permettre de modéliser électriquement la paroi générée avec un modèle fiable et représentatif d'un fonctionnement réel. Une simulation permet d'améliorer le modèle en comparant les résultats d'une simulation avec des données extraites d'un test sur un patient. A titre d'exemple, la période d'un circuit de propagation électrique autoentretenu qui est modélisé et déterminable par un simulateur peut être comparée avec la période constatée sur un système d'imagerie représentant l'activité électrique du cœur.

Selon un mode de réalisation, la méthode comporte une étape de simulation de la propagation d'un courant électrique dans un modèle de la paroi du myocarde généré permettant de déterminer la présence d'au moins un circuit de propagation électrique singulier, ledit circuit de propagation électrique singulier étant un circuit périodique auto-entretenu ou un circuit comportant deux boucles.

Selon un mode de réalisation, la simulation électrique comprend une détermination de la période d'un circuit de propagation électrique singulier grâce à un système d'imagerie. Avantageusement, le système d'imagerie peut être couplé à un calculateur qui permet d'analyser la vitesse de propagation d'un signal sur une portion formant par exemple une boucle.

Selon un mode de réalisation, la détermination de la période d'un circuit de propagation électrique singulier comprend la détection d'une portion du circuit dans laquelle la circulation électrique est ralentie. Un avantage est de déterminer une portion donnée d'un circuit causant un retard de propagation. Un avantage est donc de permettre de planifier une action localisée sur une partie d'une zone singulière identifiée par le procédé de l'invention.

Selon un mode de réalisation, la simulation de la propagation d'un courant électrique dans un modèle de la paroi du myocarde généré permet de déterminer au moins une activation d'une zone du myocarde décalée spatialement et/ou temporellement vis-à-vis du début de l'activation du myocarde modélisé. Un avantage est d'étudier par exemple à partir d'un système d'imagerie affichant l'image du modèle de paroi obtenu par le procédé de l'invention, la propagation électrique dans la zone d'intérêt. Cette propagation peut être immédiatement comparée avec la propagation électrique dans une zone singulière identifiée par le procédé. L'analyse du retard de propagation électrique dans une zone singulière permet d'isoler les effets possibles de cette zone sur la propagation générale dans le modèle de paroi. Le procédé de l'invention permet de prendre en considération la position de la zone singulière identifiée et donc de prendre en considération les décalages spatiaux et temporelles naturels du fait de la position de la zone singulière. Cette prise en compte permet d'isoler les effets de retard de propagation électrique résultant uniquement de la géométrie d'une zone singulière.

Selon un mode de réalisation, la méthode comporte une détermination d'au moins un isthme induisant un gradient électrique entre au moins deux volumes, la géométrie dudit isthme étant déterminée par au moins un paramètre parmi lesquels :
▪ Un rapport donné entre une épaisseur d'au moins deux zones adjacentes à l'isthme et une épaisseur de la zone formant ledit isthme ;
▪ Une largeur donnée de la zone formant l'isthme caractérisée par un écartement minimum, moyen ou maximum entre deux zones adjacentes à la zone formant ledit isthme ;
▪ Une longueur donnée de la zone formant l'isthme formée par une forme de couloir ou de crête définie par l'agencement des zones adjacentes ;
▪ Une topologie donnée d'entrée ou de sortie de l'isthme susceptible de former des zones ayant sensiblement la forme d'entonnoir ou d'une portion d'entonnoir ;
▪ Une courbure locale de l'isthme telle que la courbure d'entrée et la courbure de sortie de l'isthme.

Selon un mode de réalisation, une combinaison de ces caractéristiques peut être prise en compte pour discriminer des zones géométriques singulières. Un avantage est de déterminer les typologies des zones singulières pouvant être la source d'une propriété électrique induisant par exemple une arythmie. Lors de simulations l'annulation des effets électriques d'une zone singulière donnée permet d'étudier l'influence de cette zone sur la propagation d'une stimulation.

Selon un mode de réalisation, au moins un des paramètres caractérisant la géométrie d'une zone susceptible de former un isthme est comparée à une valeur seuil permettant de discriminer la catégorie de la forme parmi le groupe {isthme ; pas d'isthme}. Un avantage est d'automatiser un procédé de manière à analyser ensuite un ensemble de zones ayant été identifiée chacune comme pouvant possiblement former un isthme du fait des caractéristiques qui ont été préalablement comparées automatiquement.

Selon un mode de réalisation, le seuil d'intérêt Si est de 5mm et le seuil maximal est compris entre 6mm et 12mm. Selon un exemple dans lequel on souhaite resserrer les zones d'intérêt, le seuil d'intérêt peut être réduit à 4mm. Selon certaines zones du myocarde dans lesquelles on connait d'avance une particularité de la paroi, par exemple si une cicatrice est connue dans une zone ou si la zone concerne par exemple un endroit particulier tel que l'Apex, alors le seuil d'intérêt peut prendre en considération ces données afin de mieux cibler la zone à extraire.

Selon un autre aspect, l'invention concerne un système comportant une mémoire comportant des données de références et de paramétrage et un calculateur pour réaliser les étapes de la méthode de l'invention.

Notamment, la mémoire peut stocker les images qui seront traitées, des données de configuration telles que celles qui permettent de configurer la segmentation et les données d'attribution de valeurs d'un paramètre électro-physiologique le cas échéant.

Le calculateur permet d'effectuer les traitements visant à segmenter les images selon la configuration choisie, de générer le modèle de paroi selon le mode de réalisation déterminée. En outre, le calculateur peut mettre en œuvre les algorithmes de reconnaissances de forme ou les algorithmes visant à déterminer des zones singulières géométriquement ou électriquement. Le calculateur peut effectuer les calculs visant à déterminer les solutions d'une équation visant à identifier des zones singulières du modèle.

Selon un mode de réalisation, le système de l'invention comporte, en outre, un système d'imagerie pour visualiser une simulation d'une propagation électrique dans un modèle de paroi généré. Le système d'imagerie peut par exemple être configuré pour identifier des zones de propagation électrique singulière. Le système d'imagerie peut être configuré pour déterminer une période de parcours du courant dans un circuit électrique autoentretenu.

Selon un mode de réalisation, le système de l'invention comporte, en outre, un moyen pour mesurer l'activité électrique du cœur afin de comparer la périodicité d'un évènement électrique avec une période mesurée d'un circuit électrique singulier détecté. Parmi les moyens envisageables, des électrodes de surface peuvent être utilisées. A titre d'exemple une ceinture ou veste d'électrodes peut être utilisée. Selon un autre exemple un cathéter.

### BREVE DESCRIPTION DES FIGURES

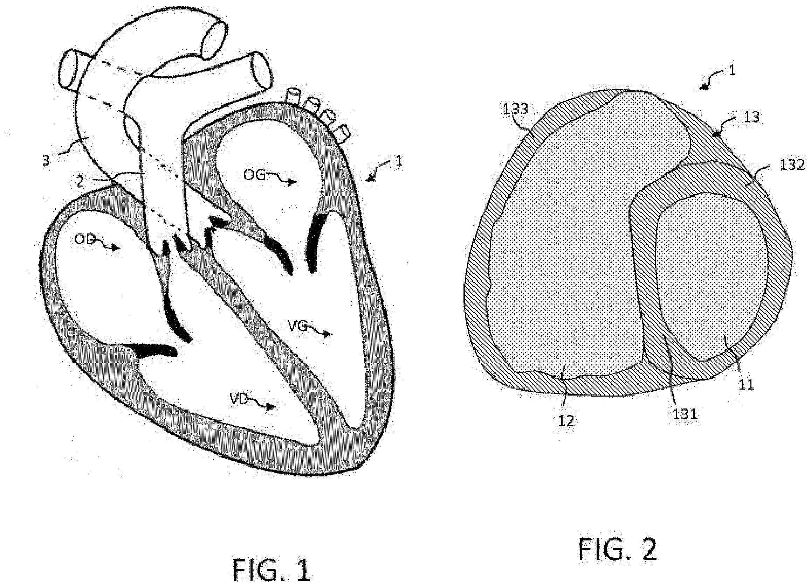

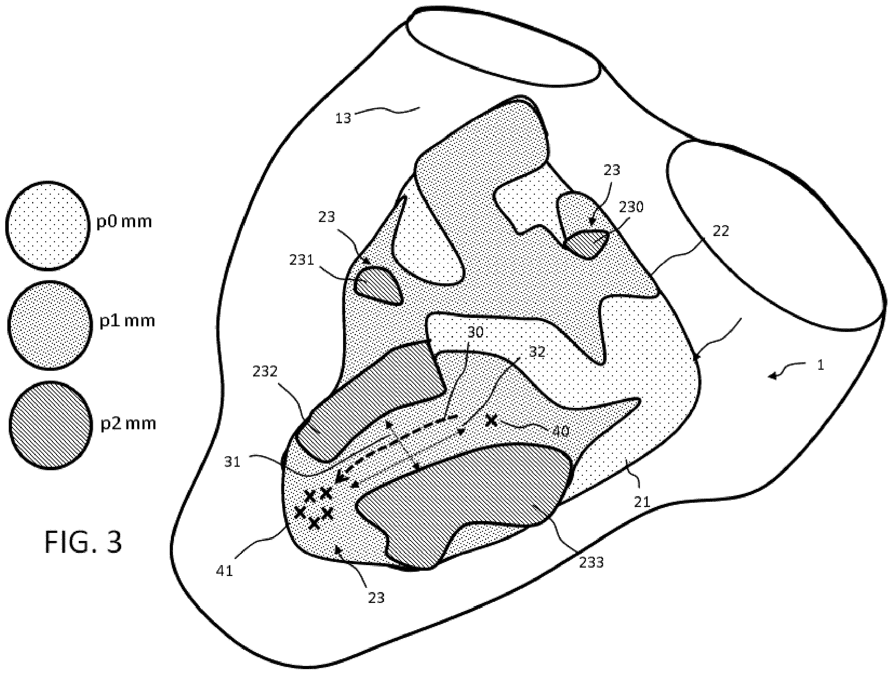

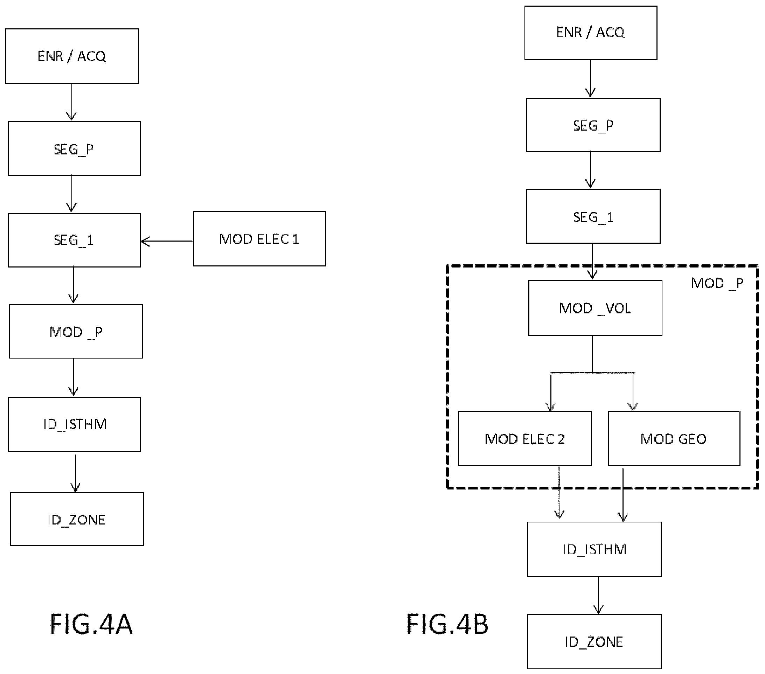

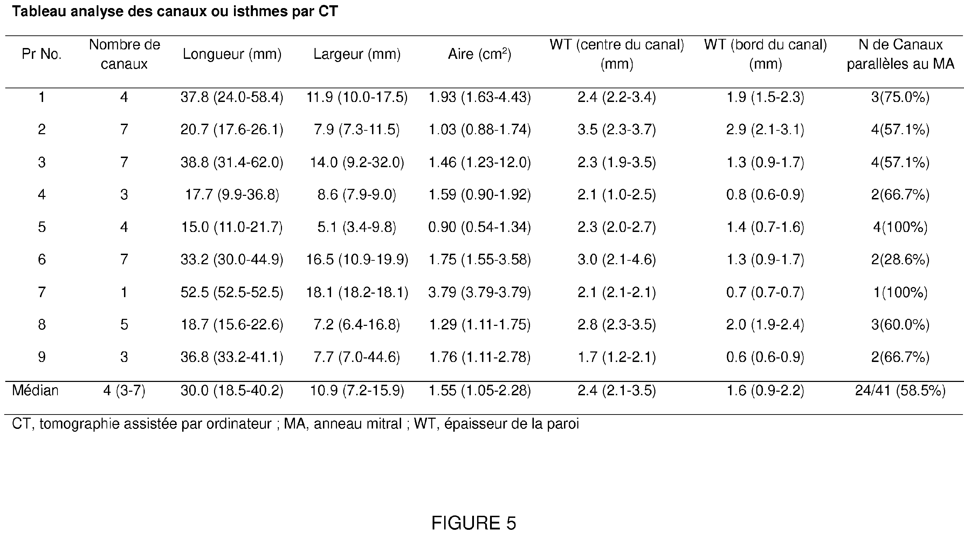

D'autres caractéristiques et avantages de l'invention ressortiront à la lecture de la description détaillée qui suit, en référence aux figures annexées, qui illustrent :
▪ figure 1 : une vue d'un cœur et des régions formant des cavités et des parois ;
▪ figure 2 : une coupe d'une image tridimensionnelle du cœur capturée par un scanner avec la définition d'un plan valvulaire selon le procédé de l'invention ;
▪ figure 3 : une représentation d'une partie d'une paroi du myocarde définissant une zone d'intérêt et des volumes segmentés ;
▪ figure 4A et figure 4B : les principales étapes du procédé de l'invention ;
▪ figure 5 : les résultats de l'analyse de canaux ou isthmes par tomographie assistée par ordinateur sur un groupe de 9 patients.

### DESCRIPTION

On entend dans la présente description une zone dont la conduction électrique est singulière comme :
▪ une zone dans laquelle la conduction électrique est ralentie, c'est-à-dire qu'elle est inférieure à un seuil prédéfini, le seuil prédéfini pouvant être une fonction de différents critères ou;
▪ une zone dans laquelle la conduction électrique forme un circuit électrique autoentretenue, ou ;
▪ une zone dans laquelle la conduction électrique forme un circuit électrique comportant au moins deux boucles connectées.

On entend plus généralement une zone singulière comme :
▪ une zone ayant soit des caractéristiques de propagation électrique particulières vis-à-vis d'une portion plus large considérée ou ;
▪ une zone ayant des caractéristiques géométriques données caractérisant la présence d'un isthme. Une telle zone est appelée dans la suite « isthme » lorsqu'elle caractérise des paramètres géométriques. Les particularités géométriques d'un isthme sont caractéristiques de la présence d'un gradient électrique qui a pour conséquence d'induire une propriété de conduction électrique correspondante à une zone singulière électriquement.

On entend par « zone arythmogène » : une zone dans laquelle la circulation électrique est entretenue selon un rythme différent que le rythme sinusal cardiaque.

Dans un contexte médical, un cas d'arythmie cardiaque peut être causé par une zone arythmogène, telle qu'une cicatrice du myocarde. Le rythme causé par l'arythmie est alors anormal et perturbe le rythme cardiaque.

On précise qu'il est possible qu'une arythmie cardiaque soit causée par une autre raison que la présence d'une zone arythmogène. Inversement, la détection d'une zone arythmogène ne signifie pas automatiquement qu'elle est susceptible de créer une arythmie cardiaque. En tout état de cause, le procédé de l'invention permet de connaitre les zones arythmogènes et leur typologie afin de catégoriser ces dernières et de modéliser la propagation électrique dans le myocarde.

### Enregistrement / Acquisition de l'image

La figure 1 représente un cœur 1 humain. Sont représentés sur la figure 1, au sein du cœur 1 : un ventricule gauche, noté VG, un ventricule droit, noté VD, une oreillette droite, notée OD, et une oreillette gauche, notée OG.

Dans la suite de la description, nous nommons « cavité » un volume sanguin circulant contenu dans le cœur et limité par des parois cardiaques. Il existe 4 cavités dans le cœur : un ventricule gauche VG, un ventricule droit VD, une oreillette droite OD et une oreillette gauche OG.

Les cavités accueillent un débit de sang qui transite entre les différentes artères, veines et valves 2, 3 reliant certains volumes entre eux.

Le procédé de l'invention comprend une étape comportant un enregistrement d'une image 3D du cœur ou d'une région du cœur. L'image peut être directement acquise à partir d'un dispositif d'acquisition d'une image telle qu'un scanner ou une IRM. Alternativement, l'image peut être obtenue par un support d'enregistrement, l'image ayant déjà été réalisée préalablement au procédé de l'invention.

L'étape d'enregistrement notée ENR à la figure 4 illustre cette première étape du procédé. Elle peut être précédée d'une étape d'acquisition d'images notées ACQ et représentée à la même étape que l'étape d'enregistrement ENR à la figure 4. L'étape d'acquisition peut être réalisée par un équipement permettant de réaliser une image d'un cœur d'un patient ou d'un animal.

Préférentiellement, l'image acquise comporte au moins une cavité telle que le ventricule droit VD ou le ventricule gauche VG ou une des oreillettes OD, OG ainsi que la paroi entourant ladite cavité. Cette paroi comprend un muscle appelé myocarde, et s'étend depuis une limite interne appelée « endocarde » jusqu'à une limite externe appelée « épicarde ».

La figure 2 représente une vue de coupe d'une image 3D de la figure 1 d'un cœur acquise au moyen d'un scanner. Différentes zones apparaissent dont :
- une zone 12 délimitant la cavité du ventricule droit VD ;
- une zone 133 délimitant la paroi du ventricule droit VD ;
- une zone 11 délimitant la cavité du ventricule gauche VG ;
- une zone 132 délimitant la paroi du ventricule gauche VG ;
- une zone 131 délimitant la paroi située entre les deux ventricules gauche et droit, appelée le septum.

Les parois 131, 132, 133 sont une unique paroi musculaire notée plus généralement 13 dans la suite de la description. Cette paroi entoure les différentes cavités.

Selon un mode de réalisation, le procédé de l'invention comprend un enregistrement d'une image 3D potentiellement acquise préalablement, par exemple au moyen d'un scanner. Cette étape d'acquisition est notée ACQ à la figure 4, elle est optionnelle.

A titre d'exemple, notons que l'acquisition de l'image peut relever de la tomodensitométrie également appelée « scanographie ». Ces techniques sont également identifiées comme le CT-scan ou le CAT-scan et reposent sur la mesure de l'absorption des rayons X par les tissus d'un organe. La numérisation des images permet de reconstruire l'image 3D des structures anatomiques de la région observée.

Dans la suite de la description, on parle indifféremment d'une « image représentant une paroi du myocarde » ou d'une « paroi du myocarde » par abus de langage dans la mesure où l'invention concerne la génération d'un modèle du myocarde et donc au moins d'une image de ce dernier pour en extraire des informations géométriques et/ou électriques.

### Segmentation préalable: région d'intérêt

L'image générée 3D comprend une répartition volumétrique de pixels. Une région d'intérêt peut alors être considérée. Le procédé de l'invention permet de considérer par exemple la paroi 13 du cœur, plus connue sous le nom de myocarde. Selon un mode de réalisation, une région d'intérêt 21 peut alors être extraite selon un critère d'épaisseur de paroi. Par exemple, une région d'intérêt est définie pour une épaisseur du myocarde inférieure à 5mm. La définition d'un seuil d'épaisseur Si de la région d'intérêt 21 permet d'extraire automatiquement ladite région d'intérêt par le traitement de l'image, ce seuil est appelé « seuil d'intérêt ». Le seuil d'intérêt Si peut être configuré selon la région du cœur considérée. Ainsi, au niveau de l'Apex la région d'intérêt peut avoir un seuil d'intérêt Si de 4mm et dans une autre région le seuil d'intérêt Si peut être pris égal à 5mm. Dans cette configuration, les zones d'intérêts extraites sont considérées indépendamment l'une de l'autre en fonction de leur seuil d'intérêt Si respectif.

Selon un mode de réalisation, un traitement d'image est mis en œuvre pour extraire au moins une région d'intérêt 21 en considérant pour chaque point du myocarde 13 l'épaisseur de ce dernier et en comparant cette épaisseur à un seuil maximal Sₘₐₓ. Cette étape est notée SEG_P, elle consiste en une pré-segmentation d'une partie du myocarde de manière à réaliser la segmentation des différents volumes SEG_1 sur la base d'une partie uniquement du myocarde. Alternativement, la segmentation SEG_1 est effectuée directement à partir de l'image enregistrée.

Selon un mode de réalisation, le seuil maximal Sₘₐₓ est configurable selon un critère de poids, d'âge ou de sexe, etc. Le seuil maximal Sₘₐₓ permet de définir une limite maximale d'épaisseur du myocarde permettant de définir une région d'intérêt à extraire afin de segmenter l'épaisseur d'une partie du myocarde. Selon un mode de réalisation, le seuil maximal Sₘₐₓ peut résulter d'un algorithme dépendant d'un histogramme caractérisant un ensemble de paramètres relatifs à un contexte donné.

La figure 3 représente un modèle MOD_P généré à partir du procédé de l'invention. Le modèle MOD_P comporte une image tridimensionnelle du myocarde dont la paroi a été segmentée selon le procédé de l'invention.

Selon un mode de réalisation, une partie de l'image tridimensionnelle est traitée par le procédé de l'invention, il s'agit de la région d'intérêt 21. Selon un mode de réalisation, la région d'intérêt 21 est définie pour une épaisseur du myocarde inférieure à 5mm. Cette solution permet de considérer une seule partie de l'image. Un avantage est de diminuer les temps de calculs tout en permettant de générer un modèle MOD_P dans lequel des singularités géométriques et/ou des singularités de propagation électrique peuvent être identifiées et localisées.

Selon un autre mode de réalisation, une région d'intérêt est définie par toute la paroi du myocarde 13. Dans ce cas, la segmentation du procédé de l'invention s'applique à toute la paroi du myocarde. La pré-segmentation SEG_P représentée à la figure 4 n'est alors pas réalisée. Cette étape est optionnelle.

La figure 3 représente une image comportant différents volumes de la région d'intérêt 21, dont les volumes 22, 230, 231, 232 et 233. Plus particulièrement, la figure 3 représente plusieurs volumes 23 notés ainsi du fait qu'ils comprennent la même épaisseur. Ils sont, par ailleurs, notés 230, 231, 232 et 233 de manière à les différencier, notamment pour décrire les parties adjacentes à l'isthme 30. Le procédé de l'invention permet de segmenter ces différents volumes afin d'identifier des singularités électriques :
▪ soit de manière géométrique en identifiant des isthmes tels que l'isthme 30 qui est compris entre les deux portions 232 et 233 d'épaisseurs inférieures à celle de la portion 30 ;
▪ soit de manière électrique en associant à chaque volume segmenté un paramètre électro-physiologique, le volume pouvant être défini au niveau du pixel ou au niveau d'un ensemble de pixels de manière à réaliser une simulation électrique pour identifier des comportements électriques particuliers.

Parmi les paramètres électro-physiologiques, on trouve notamment pour les différentes mises en œuvre du procédé de l'invention : l'amplitude du potentiel transmembranaire, la vitesse de conduction électrique, la durée du potentiel d'action, une caractéristique de la courbe de restitution.

### Segmentation de la paroi modélisée

La figure 4A illustre un premier mode de réalisation de l'invention pour générer le modèle MOD_P.

L'étape de segmentation des volumes est notée SEG_1 à la figure 4A.

Selon ce premier mode de réalisation, chaque point de la paroi est considéré de proche en proche pour lui associer une valeur d'au moins un paramètre électro-physiologique. Ce premier mode de réalisation permet d'intégrer donc dans l'étape de segmentation une attribution de valeurs d'un paramètre électro-physiologique à des points de la paroi, tels que des pixels ou des voxels. L'étape de segmentation SEG_1 est alors réalisée conjointement à une étape de modélisation électrique MOD_ELEC_1 pour générer un modèle MOD_P.

La figure 4B illustre un second mode de réalisation de l'invention pour générer le modèle de paroi MOD_P.

Selon ce second mode de réalisation, le procédé comprend une étape de modélisation des épaisseurs notée MOD_VOL générée à partir de l'opération de segmentation SEG_1. Dans cette étape, chaque volume est segmenté selon une fonction de l'épaisseur. La segmentation SEG_1 est réalisée selon une définition des paliers d'épaisseur qui peut être préconfigurée. La discrétisation des paliers, c'est-à-dire leur nombre, peuvent être notamment pris en compte.

Selon une variante, ce second mode de réalisation comprend une étape d'association/attribution effectuée après l'opération de segmentation SEG_1, par une modélisation notée MOD_ELEC_2 dans la figure 4B pour générer un modèle du myocarde MOD_P. Cette modélisation électrique est effectuée à partir d'une modélisation des épaisseurs MOD VOL générée à partir de l'opération de segmentation SEG_1. Lorsque l'opération de segmentation SEG_1 est terminée, une valeur d'un paramètre électro-physiologique est ensuite attribuée à chaque volume segmenté. Cette association peut donc être subséquente à la segmentation SEG_1.

Selon une autre variante, le procédé comprend la définition d'une pluralité de volumes d'épaisseurs différentes segmentés à l'étape SEG_1 afin de générer un modèle d'épaisseur MOD VOL. Le modèle MOD VOL est ensuite utilisé pour caractériser géométriquement des zones d'intérêts de la paroi du myocarde. L'étape de caractérisation géométrique de certaines zones de la paroi 20 ou 21 est notée MOD_GEO. Cette caractérisation peut être ensuite éventuellement corroborée à des modèles d'activité électrique.

Selon un premier mode de réalisation et en référence à la figure 4A, la segmentation de tous les volumes est effectuée selon un critère d'épaisseur en même temps que l'attribution d'un paramètre électro-physiologique pour chaque volume. Le modèle de paroi MOD_P est généré consécutivement à cette opération d'attribution.

L'attribution entre un volume d'une épaisseur donnée et une valeur donnée d'un paramètre électro-physiologique peut être effectuée de manière discrète par tranches de valeurs ou peut être effectuée grâce à une fonction continue.

Selon un premier exemple, considérons quatre volumes de parois segmentés V1, V2, V3, V4 par trois seuils compris entre 0 et 5mm : S1 = 1mm ; S2 = 3mm ; S3 =4mm. Dans ce premier exemple, le paramètre électro-physiologique est une vitesse de propagation de courant comprise entre 0 et 4m/s. On segmente les valeurs de vitesse de propagation selon des gammes de valeurs. Une première gamme G1 est comprise entre [0 et 0,5m/s], une seconde gamme G2 est comprise entre [0,5 et 1,5m/s], une troisième gamme G3 est comprise entre [1,5 et 2,5m/s], une quatrième gamme G4 est comprise entre [2,5 et 4m/s].

Selon ce premier exemple, le procédé de l'invention est capable d'associer chaque volume V1, V2, V3, V4 à chacune des gammes G1, G2, G3, G4.

Selon un second exemple, l'association des volumes et des valeurs d'au moins un paramètre électro-physiologique est réalisée à partir d'une fonction continue associant les épaisseurs à des valeurs d'au moins un paramètre électro-physiologique selon un paramètre de distribution. Le paramètre de distribution permet d'ajuster le modèle de la fonction continue utilisée.

Dans ce second exemple, la fonction peut être appliquée lors du traitement de l'image. Les étapes de segmentation sont alors réalisées conjointement à l'étape d'attribution des valeurs du paramètre électro-physiologique. Selon un mode de réalisation, un algorithme d'association pour le traitement d'image effectue les opérations de proche en proche. Un premier point de la paroi est considéré, un calcul de l'épaisseur de la paroi en ce point est effectué, une attribution d'une valeur d'un paramètre électro-physiologique est associé à cette valeur d'épaisseur en ce point. Un modèle est alors réalisé grâce à l'algorithme d'association.

Selon une première variante de réalisation, un paramètre électro-physiologique considéré est la vitesse de propagation du courant dans la paroi du myocarde. On considère un modèle de propagation de courant qui dépend de l'épaisseur du myocarde qui peut alors être intégré lors de l'opération de segmentation de la paroi. Selon un premier exemple, le modèle peut être un modèle discret dans lequel des vitesses de courant sont associées à une épaisseur. Selon un autre exemple, le second modèle peut être un modèle continu. Dans ce dernier cas l'intégration de ce modèle est réalisée à partir d'une fonction de distribution continue.

Selon une seconde variante de réalisation, un paramètre électro-physiologique considéré est une donnée caractérisant un potentiel d'action d'une partie du myocarde. Le potentiel d'action peut être caractérisé par notamment une amplitude et/ou une durée du potentiel d'action.

Selon une autre variante de réalisation, un paramètre électro-physiologique considéré est une impédance ou une résistance locale du tissu formant la paroi du myocarde.

### Second mode de réalisation

Selon un second mode de réalisation et en référence à la figure 4B, la segmentation de la paroi 20 ou 21 en une pluralité de volumes 22, 23 est effectuée sans qu'une attribution particulière à un paramètre électro-physiologique ne soit effectuée. Les volumes 22, 23 sont ensuite caractérisés géométriquement afin de déterminer des zones d'intérêts susceptibles de conduire un courant dans la paroi du myocarde selon une vitesse de propagation différente, par exemple supérieure, à la vitesse de propagation du courant circulant dans une zone de la paroi du myocarde peu conductrice. Une zone peu conductrice est caractérisante d'une zone nécrosée ou d'une zone dans laquelle le muscle n'est plus assez conducteur électriquement.

La caractérisation géométrique de zones d'intérêt est obtenue par une étape de détermination d'un certain nombre de caractéristiques géométriques d'au moins un isthme formé, tel que l'isthme 30, dans la paroi du myocarde 20. Un isthme 30 est défini par :
▪ son épaisseur au regard d'épaisseurs de zones adjacentes 232, 233. Il s'agit donc de retenir un écart d'épaisseurs pour évaluer la « hauteur » relative de l'isthme.
▪ sa largeur 31 formée par l'écartement desdites zones adjacentes 232, 233. Une largeur médiane, moyenne, minimale ou encore maximale peut être considéré selon différents exemples de réalisation. Selon d'autres exemples de réalisation, différentes mesures peuvent être effectuées pour prendre en compte une topologie particulière de l'évolution de la largeur d'un isthme.
▪ sa longueur 32 formée par le couloir ou la crête défini(e) par l'agencement des zones adjacentes 232, 233.
▪ La topologie de l'entrée et de la sortie d'un isthme 30 peut être prise en compte, telle que l'entonnoir formé par les deux zones adjacentes 232 et 233 qui permettent d'évaluer le comportement d'une concentration de charges électriques et donc d'un débit de courant et donc d'une vitesse de propagation électrique à l'entrée ou à la sortie d'un isthme.

En ce qui concerne les topologies d'entrée et de sortie de l'isthme qui sont susceptibles de former des zones de concentration ou des zones débouchantes modifiant les vitesses de propagation du courant circulant à la surface du myocarde, différentes techniques de détection peuvent être utilisées. Ces zones peuvent être caractérisées, par exemple, par la convergence ou la divergence des deux zones adjacentes à l'une ou l'autre de l'extrémité de l'isthme. La convergence ou la divergence des zones adjacentes peut être, par exemple, obtenues par une mesure des tangentes ou une mesure visant à caractériser la forme de l'entonnoir définie par les deux zones adjacentes.

Selon un mode de réalisation, les courbures d'entrées et/ou de sortie d'un isthme peuvent être calculées pour discriminer la pertinence de la singularité d'un isthme.

La singularité d'un isthme permet de caractériser une zone du modèle du myocarde notamment en ce qui concerne la propagation de la conduction électrique supposée se produire dans cette zone du fait de la présence de l'isthme et de sa typologie. L'isthme peut en première approximation être caractérisé par un gradient électrique local qui est généré entre deux volumes segmentés.

Selon un mode de réalisation, plusieurs critères géométriques sont pris ensemble et combinés de manière à optimiser la discrimination d'un isthme singulier.

Selon un mode de réalisation, des valeurs de références définissant des seuils de comparaisons des paramètres géométriques cidessus permettent de discriminer un isthme ou de catégoriser un type d'isthme. Selon un mode de réalisation, ces valeurs permettent d'évaluer un paramètre électrique associé à l'isthme tel que la vitesse de propagation électrique dans l'isthme ou le débit de courant y transitant.

Ces paramètres évalués permettent de discriminer, voire de catégoriser et d'évaluer un type d'isthme. Les valeurs de références peuvent être pondérées ou adaptées selon des paramètres tels qu'un volume du cœur, un âge de cellule ou de patient, un taux de graisse présent dans le myocarde ou encore de données d'antécédents d'un patient.

Selon un mode de réalisation, les valeurs de ces paramètres peuvent être automatiquement calculées à partir d'un algorithme de reconnaissance de formes ou un algorithme morphologique ou d'une fonction particulière permettant d'identifier les singularités définissant la présence d'un isthme.

L'étape d'identification d'un isthme répondant à certains critères prédéfinis est notée ID_ISTHM.

Optionnellement, le procédé de l'invention comprend selon un mode de réalisation de l'invention une étape notée ID_ZONE susceptibles de former une zone de concentration de charges à la sortie ou à l'entrée d'un isthme.

Un intérêt de l'invention est donc de prendre en compte notamment l'épaisseur, la largeur et la longueur de zones formant des isthmes afin de modéliser des zones susceptibles de conduire le courant à des vitesses de propagation supérieures à celles dans lesquelles le courant se propage à une vitesse ralentie du fait d'une particularité du myocarde.

### Modélisation géométrique par génération d'une fonction à 2 variables pour modéliser la paroi

Selon un mode de réalisation, le modèle de la paroi MOD_P du myocarde comporte la génération d'un modèle de l'épaisseur de la paroi modélisée par une fonction à deux variables et la détermination de maximas formant des lignes continues.

Selon un mode de réalisation, les maximas sont déterminés à partir de la détermination des zéros de la fonction dérivée et de l'analyse de la valeur du déterminant de la fonction Hessienne pour les zéros déterminés.

Selon un mode de réalisation, le modèle de la paroi MOD_P du myocarde comporte la discrimination des lignes déterminées dont l'épaisseur de paroi correspondante est supérieure à un seuil prédéfini.

Selon un mode de réalisation, le procédé de l'invention comporte un calcul des dérivées et des fonctions Hessienne directement dans le modèle à trois dimensions afin de déterminer des vecteurs propres qui permettront de discriminer la présence ou non d'isthme(s).

Selon un mode de réalisation, le procédé comporte :
- une identification d'au moins une zone débouchante d'un isthme ;
- une ablation de ladite zone débouchante.

Selon un mode de réalisation, le procédé comporte une simulation de la propagation d'un courant électrique dans le modèle de paroi généré. La simulation électrique comporte l'injection d'un courant dans le modèle de la paroi MOD_P avec une modélisation électrique de la paroi. L'injection d'un courant peut par exemple modéliser l'activation électrique du myocarde. Le courant injecté peut être par exemple de type sinusoïdal. Différents scénarios de génération d'un courant électrique permettant d'induire une simulation donnée peuvent être configurés.

La simulation du modèle de paroi comprend la définition d'une stimulation virtuelle qui, in Silico, pourrait permettre de modéliser électriquement des zones de conduction électrique singulières dans la paroi et pourrait donc permettre de détecter des zones ayant des caractéristiques de conduction électrique particulière. En outre, ces zones peuvent être éventuellement associées à un facteur de criticité par exemple représentatif d'une probabilité de survenance d'un circuit l'arythmie. En effet, cette stimulation virtuelle pourrait déclencher une tachycardie ventriculaire virtuelle et le trajet intra-cicatriciel du circuit pourrait être utilisé pour définir les cibles à traiter pendant une intervention d'ablation par cathéter. Cette stratégie pourrait être particulièrement pertinente chez des patients pour lesquelles l'arythmie n'est pas inductible cliniquement ou trop mal tolérée pour être cartographiée.

Selon un exemple de réalisation, lorsque la stimulation in Silico déclenche une arythmie ventriculaire virtuelle, une ablation virtuelle de la partie intra-cicatricielle du circuit pourrait être réalisée pour confirmer que l'arythmie n'est plus inductible. Ce processus pourrait être répété virtuellement tant qu'il y a une tachycardie inductible.

Ainsi le procédé de l'invention pourrait favoriser la pratique prévenante d'opérations chirurgicales virtuelles en vue de préparer une opération réelle.

Des stimulations d'un nombre important de sites dans et autour d'une zone d'intérêt, telle qu'une cicatrice, d'un modèle de paroi pourraient être utilisées pour la prédiction du risque d'arythmie ventriculaires. Une des limites de la stimulation clinique, chez un patient, est le fait qu'on ne peut stimuler que 2 à 3 sites. Un model in Silico n'a virtuellement pas de limite quant au nombre de sites sur lesquelles un protocole de stimulation programmée peut être appliqué. Le test serait considéré comme positif si une arythmie ventriculaire est effectivement virtuellement inductible.

Ainsi, la réalisation d'un modèle de paroi permet de réaliser de nombreux tests afin de catégoriser les circuits de propagation électrique singuliers détectés grâce au procédé de l'invention.

Selon un mode de réalisation de l'invention, le comportement des signaux électriques singuliers dans une zone d'intérêt peut également être étudié. Un indice de singularité peut être défini en fonction du couplage ou non, ou encore d'un degré de couplage entre les signaux électriques singuliers détectés avec le reste du myocarde. Le découplage peut par exemple résulter d'une activation électrique des zones électriques singulières avec des délais croissants lors de la stimulation.

Selon un mode de réalisation, une cartographie virtuelle peut être rassemblée sur un même modèle cumulant les cartes de signaux électriques singuliers obtenues pour tous les sites de stimulation virtuelle. On sait en effet que le site de stimulation importe et permet de révéler des signaux électriques singuliers autrement masqués.

Ce type de stimulation virtuelle pourrait ainsi améliorer la détection des patients à risque et devenir une aide significative dans la décision d'implantation d'un défibrillateur.

La simulation permet alors de localiser la présence d'un circuit de propagation électrique singulier. Selon un premier exemple, un circuit électrique singulier forme une boucle parcouru par un courant selon une période T. Selon un autre exemple, un circuit électrique singulier forme un « 8 », c'est-à-dire deux boucles parcourues par un courant selon une autre période T. D'autre singularités peuvent être identifiées comportant par exemple un circuit ayant une discontinué électrique.

Le procédé de l'invention permet de discriminer un circuit de propagation électrique singulier parmi une pluralité de circuits identifiés en comparant les périodes de chacun d'entre eux avec une période donnée que l'on recherche. En effet, en rapprochant les arythmies ou des évènements particuliers dans un électrocardiogramme donné, il est possible de déterminer le circuit causant une arythmie ou un évènement électrique particulier. L'électrocardiogramme peut être obtenu à partir d'électrodes de surfaces ou d'un cathéter ou tout autre équipement permettant de mesurer une activité électrique du cœur.

Des enregistrements électrocardiographiques de surfaces ou physiologiques ou cartographiques peuvent être utilisés pour définir une période de référence. La période de référence est alors comparée automatiquement à des périodes mesurées de circuits de propagation électriques singuliers du modèle de paroi.

Selon un autre usage, les enregistrements peuvent être utilisés pour configurer ou corriger une configuration du modèle de paroi. Par exemple, lorsqu'un évènement électrique est identifié sur un enregistrement et qu'un circuit de propagation électrique singulier détecté est associé à cet événement, alors le modèle peut être corrigé, comme par exemple les valeurs d'attribution de vitesse de courant. Le modèle peut donc être affiné grâce à une prise en compte de paramètres de compensations dans la configuration du modèle de paroi.

Ainsi, le procédé, quand il est associé à un ECG de référence comportant un évènement électrique déterminable, peut servir :
▪ soit à améliorer la qualité du modèle de la paroi,
▪ soit à identifier un circuit singulier particulier parmi une pluralité de circuits candidats afin d'être rapproché d'un évènement électrique particulier de l'ECG de référence et identifié par un dispositif de mesure de l'activité électrique du cœur.

Selon un exemple de réalisation, le procédé de l'invention permet de détecter au moins un circuit de propagation électrique dans au moins une région du myocarde lorsque ce dernier est décalé temporellement et/ou spatialement par rapport au début de l'activation électrique du myocarde modélisé par le procédé de l'invention, c'est-à-dire au début de l'onde QRS. Selon un exemple de réalisation, le décalage mesuré prend en compte la distance entre la zone du début de l'activation du myocarde et la zone dans laquelle le circuit de propagation électrique singulier est mesuré. En effet, le temps de propagation de l'onde électrique peut être pris en compte dans la détermination du décalage temporel et/ou spatial.

La figure 3 représente des charges électriques 40, 41 transitant dans l'isthme 30. Les charges entrantes sont notées 40 et les charges sortantes sont notées 41. La détection ID_ISTHM des isthmes 30 permet de modéliser un comportement électrique du myocarde. La simulation d'une activité électrique cardiaque permet de détecter des singularités électriques à la surface du myocarde. Un modèle dynamique du myocarde peut être utilisé afin de mieux comprendre le comportement électrique du cœur, à des fins pédagogiques ou encore pour suivre l'évolution d'une situation dans le temps.

Lorsque l'isthme 30 est susceptible de provoquer une arythmie, il est alors possible d'utiliser le procédé de l'invention pour déterminer un lieu ID_ZONE dans lequel il est souhaitable de réaliser une ablation de cellules afin que le courant électrique ne circule plus. Cette opération permet par exemple d'éviter la formation d'un circuit de propagation électrique autoentretenu susceptible de déclencher une arythmie.

Une étude comparative a été réalisée pour évaluer l'efficacité du procédé d'identification d'isthmes selon la présente invention à partir des considérations géométriques. Pour ce faire, des cartographies d'activation de tachycardie ventriculaire (TV) sont réalisées sur 9 patients souffrant de tachycardies ventriculaires (TV) présentant des récidives avant l'étape d'ablation. Ces cartographies permettent de localiser les isthmes ou canaux qui sont la cible d'ablation dont le but est d'abolir la conduction à travers ces isthmes entre les cicatrices par des caractéristiques électrophysiologiques. Les isthmes électrophysiologiques sont ensuite comparées aux isthmes morphologiques identifiés par le procédé de la présente invention basé sur des caractéristiques géométriques. Les résultats de l'étude sont résumés à l'aide du tableau de la figure 5.

**Caractéristiques des patients** : 9 patients dont l'âge moyen au moment de l'ablation est de 57 ± 15 ans. La fraction d'éjection moyenne du ventricule gauche au moment de l'ablation est de 34% ± 7%. Les infarctus sont identifiés sur la paroi inférieure du myocarde chez 4 patients, sur la paroi antérieure chez 4 patients et latérale chez 2 patients.

**Procédé d'identification des isthmes selon le second mode de réalisation de l'invention :** les images de scanner CT-Scan sont réalisées sur ces mêmes patients 1 jour ou 3 jours avant la procédure d'ablation. Ces images ont été ensuite traitées selon le procédé de la présente invention selon les étapes suivantes :
- Segmentation des images acquises et en particulier une région d'intérêt de la paroi du cœur définie pour une épaisseur inférieure à 5 mm en une pluralité de volumes,
- Construction d'une cartographie avec des isosurfaces d'épaisseurs respectivement inférieurs à 1mm, 2mm, 3mm, 4mm et 5mm.
- Identification des isthmes morphologiques selon les caractéristiques géométriques suivantes, cette étape de caractérisation correspondant à l'étape ID_ISTHM de la figure 4B :
   ▪ Zone d'intérêt dont la paroi a une épaisseur inférieure à 5mm;
   ▪ Les isthmes morphologiques (ou canaux) ont une épaisseur inférieure à l'épaisseur des zones adjacentes, situées de part et d'autre des isthmes ;
   ▪ Les isthmes sont plus longs que larges ;

**Procédé d'identification des isthmes électrophysiologiques via la cartographie TV:** A l'aide du système de cartographie Rhythmia® (Boston Scientific, Marlborough, MA,États-Unis), une cartographie d'activité électrique anatomique tridimensionnelle des cavités cardiaques du ventricule gauche est acquise en rythme sinusal et par TV stimulé pour localiser les zones cibles d'ablation, à savoir les zones de tissu cicatriciel substrat de l'arythmie... La cartographie permet donc de localiser les isthmes (canaux) entre les cicatrices responsables des conductions à partir des caractéristiques électrophysiologiques.

**Etude comparative :** la cartographie TV et la cartographie CT-Scan sont fusionnées ensemble, cette fusion a été réalisée en projetant les points de la cartographies obtenues en rythme sinusal et par TV sur les points correspondants de la cartographie obtenue par CT-Scan en utilisant une méthode du plus proche voisin.

### Résultats et discussion :

41 isthmes morphologiques sont identifiés selon le procédé de la présente invention. La longueur, la largeur et l'aire médians des isthmes CT sont respectivement de 30,0 (18,5-40,2) mm, 10,9 (7,3-16,0) mm, et 1,55 (1,05-2,28) cm2, l'épaisseur médiane est de 2,4 (2,1-3,5) mm au niveau des isthmes, et 1,6 (0,9-2,2) mm au niveau des frontières (P <0,0001). Aucun isthme n'a été identifié dans les régions ayant une épaisseur plus fine que 1 mm et aucune région frontalière n'a été identifiée dans une région ayant une épaisseur supérieure à 4 mm.

L'étude comparative entre les isthmes morphologiques et les isthmes électrophysiologiques ont permis de démontrer de manière quantitative que tous les isthmes électrophysiologiques ont été associés à l'isthme critique d'une VT cartographiée.

Par ailleurs parmi les 41 isthmes morphologiques identifiés, 21 (51,2%) correspondaient à des isthmes électrophysiologiques critiques correspondant à des potentiels diastoliques, et 13 (37,7%) à des isthmes électrophysiologiques correspondant à des potentiels diastoliques moyens.

Cette étude montre que le procédé de la présente invention peut être utilisé comme un outil fiable pour identifier les isthmes avec une sensibilité élevée. Les informations morphologiques des isthmes peuvent être utilisées en complémentarité des isthmes électrophysiologiques pour un meilleur ciblage des zones critiques pour l'ablation.

## Revendications

1. Méthode de segmentation d'une épaisseur du myocarde issue d'une image tridimensionnelle pour la génération d'un modèle de paroi du myocarde afin de détecter au moins une circulation électrique singulière, **caractérisée en ce qu'**elle comprend :
• Un enregistrement (ACQ) d'une image tridimensionnelle d'une paroi du myocarde, ladite paroi délimitant au moins une cavité du coeur ;
• Une segmentation (SEG_1) d'une partie continue de la paroi (13) en au moins un premier volume (V1) comportant une épaisseur inférieure à un premier seuil (S1) prédéfini, ledit premier seuil (S1) étant inférieur à un seuil d'intérêt (Si) et un second volume (V2) d'une partie continue de la paroi (13) comportant une épaisseur supérieure au premier seuil (S1) et inférieur au seuil d'intérêt (Si) ;
• Une génération d'un modèle de paroi (MOD_P) du myocarde dans laquelle la partie continue de la paroi du myocarde est modélisée (MOD_VOL) selon au moins deux volumes (V1, V2), ledit modèle de paroi (MOD_P) permettant de modéliser au moins un gradient électrique entre lesdits volumes (V1, V2) afin de localiser au moins une zone de circulation électrique singulière.

2. Méthode selon la revendication 1, **caractérisée en ce qu'**elle comprend :
• une segmentation préalable (SEG_P) à la première segmentation (SEG_1) d'au moins une région d'intérêt (R1) formant une partie continue de la paroi du myocarde (13) et délimitée selon un critère d'épaisseur de paroi, l'épaisseur de la région d'intérêt étant inférieure au seuil d'épaisseur maximal (Sₘₐₓ).

3. Méthode selon l'une quelconque des revendications précédentes, **caractérisée en ce que** la segmentation (SEG_1) d'une partie de la paroi comporte une segmentation des volumes en au moins trois types d'épaisseurs dont une première épaisseur (E1) est inférieure à un premier seuil (S1) prédéfini, ledit premier seuil (S1) étant inférieur à un seuil d'intérêt (Si), une troisième épaisseur (E3) est supérieure à un second seuil (S2) prédéfini, ledit second seuil (S2) étant inférieur à un seuil d'intérêt (Si), et supérieur au premier seuil (S1), et une seconde épaisseur (E2) comprise entre le premier seuil (S1) et le second seuil (S2), les volumes ainsi segmentés formant des couches tridimensionnelles de différentes épaisseurs.

4. Méthode selon la revendication 3, **caractérisée en ce que** la segmentation (SEG_1) des volumes est réalisée selon une pluralité d'épaisseurs (E1, Eₚ₋₁, Eₚ, E_{N})_{p∈[1;N]}, une première épaisseur (E1) étant inférieure à un premier seuil (S1) prédéfini, ledit premier seuil (S1) étant inférieur à un seuil d'intérêt (Si), une P^{ème} épaisseur (Ep) comportant :
■ une épaisseur supérieure à un (P-1)^{ème} seuil prédéfini, ledit (P-1)^{ème} seuil étant inférieur à un seuil d'intérêt (Si), et
▪ une épaisseur inférieure à un P^{ème} seuil prédéfini, ledit P^{ème} seuil étant inférieur à un seuil d'intérêt (Si),
les volumes ainsi segmentés formant des couches tridimensionnelles de différentes épaisseurs.

5. Méthode selon l'une quelconque des revendications 1 à 4, **caractérisée en ce que** chaque volume segmenté comporte des dimensions correspondantes à une surface représentant la surface d'un pixel ou d'un voxel et une épaisseur correspondant à celle de la paroi au pixel/voxel considérée, la partie continue de la paroi correspondant à un ensemble d'au moins deux pixels/voxels formant une portion continue de l'image, l'ensemble des volumes segmentés de même épaisseur formant chacun une couche tridimensionnelle.

6. Méthode selon l'une quelconque des revendications 1 à 5, **caractérisée en ce que** lors de la segmentation ou la génération du modèle (MOD_P) de paroi du myocarde (13), la méthode comporte une attribution (AT) à chacun des volumes segmentés d'une valeur donnée d'au moins un paramètre électro-physiologique.

7. Méthode selon la revendication 6, **caractérisée en ce que** la segmentation d'une partie de la paroi du myocarde (13) est réalisée conjointement à une attribution de valeurs d'au moins un paramètre électro-physiologique, l'attribution étant effectuée selon une fonction associant à chaque valeur d'épaisseur une valeur d'un paramètre électro-physiologique.

8. Méthode selon la revendication 6 ou 7, **caractérisée en ce que** l'attribution de valeurs d'au moins un paramètre électro-physiologique est réalisée pixel/voxel par pixel/voxel en considérant une partie continue de la paroi (13), le modèle de paroi (MOD_P) comportant des ensembles de volumes segmentés de même épaisseur et étant associés chacun à une valeur d'au moins un paramètre électro-physiologique, lesdits ensembles formant chacun une couche tridimensionnelle.

9. Méthode selon l'une des revendications 6 à 8, **caractérisée en ce qu'**au moins un paramètre électro-physiologique est :
▪ une vitesse de propagation de courant comprise dans la gamme : [Om/s ; 4m/s] ou ;
▪ au moins une donnée caractérisant le potentiel d'action ou ;
▪ au moins une impédance électrique ou une résistance électrique locale de la paroi du myocarde modélisée.

10. Méthode selon l'une des revendications 6 à 9, **caractérisée en ce qu'**elle comporte une étape de simulation (SIMU) de la propagation d'un courant électrique dans un modèle de la paroi du myocarde (MOD_P) généré permettant de déterminer la présence d'au moins un circuit de propagation électrique singulier, ledit circuit de propagation électrique singulier étant un circuit périodique auto-entretenu ou un circuit comportant deux boucles.

11. Méthode selon la revendication 10, **caractérisée en ce que** la simulation électrique comprend une détermination de la période d'un circuit de propagation électrique singulier grâce à un système d'imagerie.

12. Méthode selon la revendication 11, **caractérisée en ce que** la détermination de la période d'un circuit de propagation électrique singulier comprend la détection d'une portion du circuit dans laquelle la circulation électrique est ralentie.

13. Méthode selon l'une des revendications 10 à 12, **caractérisée en ce que** la simulation (SIMU) de la propagation d'un courant électrique dans un modèle de la paroi du myocarde généré permet de déterminer au moins une activation d'une zone du myocarde décalée spatialement et/ou temporellement vis-à-vis du début de l'activation du myocarde modélisé.

14. Méthode selon l'une quelconque des revendications 1 à 5, **caractérisée en ce qu'**elle comporte une détermination d'au moins un isthme induisant un gradient électrique entre au moins deux volumes, la géométrie dudit isthme étant déterminée par au moins un paramètre parmi lesquels :
▪ Un rapport donné entre une épaisseur d'au moins deux zones adjacentes à l'isthme et une épaisseur de la zone formant ledit isthme ;
▪ Une largeur donnée de la zone formant l'isthme **caractérisée par** un écartement minimum, moyen ou maximum entre deux zones adjacentes à la zone formant ledit isthme ;
▪ Une longueur donnée de la zone formant l'isthme formée par une forme de couloir ou de crête définie par l'agencement des zones adjacentes ;
▪ Une topologie donnée d'entrée ou de sortie de l'isthme susceptible de former des zones ayant sensiblement la forme d'entonnoir ou d'une portion d'entonnoir ;
▪ Une courbure locale de l'isthme telle que la courbure d'entrée et la courbure de sortie de l'isthme.

15. Méthode selon la revendication 14, **caractérisée en ce qu'**au moins un des paramètres caractérisant la géométrie d'une zone susceptible de former un isthme est comparée à une valeur seuil permettant de discriminer la catégorie de la forme parmi le groupe {isthme ; pas d'isthme}.

16. Méthode selon l'une quelconque des revendications 1 à 15, **caractérisée en ce que** le seuil d'intérêt (Si) est de 5mm et que le seuil maximal est compris entre 6mm et 12mm.

17. Système comportant une mémoire comportant des données de références et de paramétrage et un calculateur configuré pour réaliser les étapes de la méthode selon l'une quelconque des revendications 1 à 16.

18. Système selon la revendication 17 **caractérisé en ce qu'**il comporte, en outre, un système d'imagerie pour visualiser une simulation d'une propagation électrique dans un modèle de paroi généré.

19. Système selon l'une quelconque des revendications 17 à 18, **caractérisé en ce qu'**il comporte, en outre, un moyen pour mesurer l'activité électrique du cœur afin de comparer la périodicité d'un évènement électrique avec un période mesurée d'un circuit électrique singulier détecté.

## Patentansprüche

1. Segmentierungsverfahren einer Dicke des Herzmuskels, die aus einem dreidimensionalen Bild hervorgegangen ist, für die Erzeugung eines Wandmodells des Herzmuskels, um wenigstens einen einzigartigen elektrischen Umlauf zu detektieren, **dadurch gekennzeichnet, dass** sie umfasst:
• eine Aufzeichnung (ACQ) eines dreidimensionalen Bildes einer Wand des Herzmuskels, wobei die genannte Wand wenigstens einen Hohlraum des Herzens begrenzt;
• eine Segmentierung (SEG_1) eines kontinuierlichen Teils der Wand (13) in wenigstens ein erstes Volumen (V1), umfassend eine geringere Dicke als ein erster vordefinierter Grenzwert (S1), wobei der genannte erste Grenzwert (S1) geringer ist als ein Grenzwert von Interesse (Si) und wobei ein zweites Volumen (V2) eines kontinuierlichen Teils der Wand (13) eine Dicke umfasst, das größer ist als der erste Grenzwert (S1) und geringer als der Grenzwert von Interesse (Si);
• eine Erzeugung eines Wandmodells (MOD_P) des Herzmuskels, bei der der kontinuierliche Teil der Wand des Herzmuskels gemäß wenigstens zwei Volumen (V1, V2) als Modell dargestellt (MOD_VOL) wird, wobei das genannte Wandmodell (MOD_P) das Darstellen als Modell wenigstens eines elektrischen Gradienten zwischen den genannten Volumen (V1, V2) zulässt, um wenigstens einen einzigartigen elektrischen Umlaufbereich zu lokalisieren.

2. Verfahren gemäß Anspruch 1, **dadurch gekennzeichnet, dass** es umfasst:
• eine vorherige Segmentierung (SEG_P) vor der ersten Segmentierung (SEG_1) wenigstens einer Region von Interesse (R1), die einen kontinuierlichen Teil der Wand des Herzmuskels (13) bildet und gemäß einem Wanddicken-Kriterium begrenz wird, wobei die Dicke der Region von Interesse geringer ist als der maximale Dickengrenzwert (Sₘₐₓ).

3. Verfahren gemäß irgendeinem der voranstehenden Ansprüche, **dadurch gekennzeichnet, dass** die Segmentierung (SWG_1) eines Teils der Wand eine Segmentierung der Volumen in wenigstens drei Dickentypen umfasst, von der eine erste Dicke (E1) geringer ist als ein vordefinierter erster Grenzwert (S1), wobei der genannte erste Grenzwert (S1) geringer ist als ein Grenzwert von Interesse (Si), eine dritte Dicke (E3) größer ist als ein zweiter vordefinierter Grenzwert (S2), wobei der genannte zweite Grenzwert (S2) geringer ist als ein Grenzwert von Interesse (Si) und größer als der erste Grenzwert (S1) und eine zweite Dicke (E2) zwischen dem ersten Grenzwert (S1) und dem zweiten Grenzwert (S2) inbegriffen ist, wobei die auf diese Weise segmentierten Volumen dreidimensionale Schichten unterschiedlicher Dicken bilden.

4. Verfahren gemäß Anspruch 3, **dadurch gekennzeichnet, dass** die Segmentierung (SEG_1) der Volumen gemäß einer Vielzahl von Dicken (E1, Eₚ₋₁, Eₚ, E_{N})_{pε[1; N]} realisiert wird, wobei eine erste Dicke (E1) geringer ist als ein erster vordefinierter Grenzwert (S1), wobei der genannte erste Grenzwert (S1) geringer ist als ein Grenzwert von Interesse (Si), wobei die P. Dicke (Ep) umfasst:
• eine größere Dicke als ein (P-1). vordefinierter Grenzwert, wobei der genannte (P-1). Grenzwert geringer ist als ein Grenzwert von Interesse (Si) und
• eine geringere Dicke als ein P. vordefinierter Grenzwert, wobei der genannte P. Grenzwert geringer ist als ein Grenzwert von Interesse (Si),
wobei die auf diese Weise segmentierten Volumen dreidimensionale Schichten unterschiedlicher Dicken bilden.

5. Verfahren gemäß irgendeinem der Ansprüche 1 bis 4, **dadurch gekennzeichnet, dass** jedes segmentierte Volumen Abmessungen, die einer Oberfläche entsprechen, die die Oberfläche eines Pixels oder Voxel darstellt, und eine Dicke umfasst, die der der Wand mit dem betrachteten Pixel/Voxel entspricht, wobei der kontinuierliche Teil der Wand einer Gruppe von wenigstens zwei Pixeln/Voxeln entspricht, die einen kontinuierlichen Abschnitt des Bildes bilden, wobei die Gruppe der segmentierten Volumen mit derselben Dicke jeweils eine dreidimensionale Schicht bilden.

6. Verfahren gemäß irgendeinem der Ansprüche 1 bis 5, **dadurch gekennzeichnet, dass** bei der Segmentierung oder der Erzeugung des Modells (MOD_P) der Wand des Herzmuskels (13) das Verfahren eine Zuordnung (AT) eines bestimmten Wertes wenigstens eines elektrisch-physiologischen Parameters zu jedem der segmentierten Volumen umfasst.

7. Verfahren gemäß Anspruch 6, **dadurch gekennzeichnet, dass** die Segmentierung eines Teils der Wand des Herzmuskels (13) gemeinsam mit einer Zuordnung von Werten wenigstens eines elektrisch-physiologischen Parameters realisiert wird, wobei die Zuordnung gemäß einer Funktion durchgeführt wird, die jedem Dickenwert einen Wert eines elektrisch-physiologischen Parameters zuordnet.

8. Verfahren gemäß Anspruch 6 oder 7, **dadurch gekennzeichnet, dass** die Zuordnung von Werten wenigstens eines elektrisch-physiologischen Parameters Pixel/Voxel für Pixel/Voxel unter Berücksichtigung eines kontinuierlichen Teils der Wand (13) realisiert wird, wobei das Wandmodell (MOD_P) Gruppen von segmentierten Volumen derselben Dicke umfasst und die jeweils einem Wert wenigstens eines elektrisch-physiologischen Parameters zugeordnet sind, wobei die genannten Gruppen jeweils eine dreidimensionale Schicht bilden.

9. Verfahren gemäß einem der Ansprüche 6 bis 8, **dadurch gekennzeichnet, dass** wenigstens ein elektrisch-physiologischer Parameter ist:
▪ eine Strom-Verbreitungsgeschwindigkeit, die in dem Bereich: [0 m/Sek.; 4 m/Sek.] inbegriffen ist, oder
▪ wenigstens ein Datenelement, das das Aktionspotenzial kennzeichnet; oder
▪ wenigstens eine elektrische Impedanz oder ein lokaler elektrischer Widerstand der Wand des als Modell gestalteten Herzmuskels.

10. Verfahren gemäß einem der Ansprüche 6 bis 9, **dadurch gekennzeichnet, dass** es einen Simulationsschritt (SIMU) der Verbreitung eines elektrischen Stroms in einem erzeugten Modell der Wand des Herzmuskels (MOD_P) umfasst, was das Bestimmen des Vorhandenseins wenigstens eines einzigartigen elektrischen Verbreitungsschaltkreises zulässt, wobei der genannte einzigartige elektrische Verbreitungsschaltkreis ein selbsterhaltender periodischer Schaltkreis oder ein zwei Schleifen umfassender Schaltkreis ist.

11. Verfahren gemäß Anspruch 10, **dadurch gekennzeichnet, dass** die elektrische Simulation eine Bestimmung der Periode eines einzigartigen elektrischen Schaltkreises dank eines Bildgebungssystems umfasst.

12. Verfahren gemäß Anspruch 11, **dadurch gekennzeichnet, dass** die Bestimmung der Periode eines einzigartigen elektrischen Verbreitungsschaltkreises die Detektion eines Abschnitts des Schaltkreises umfasst, in dem der elektrische Umlauf verlangsamt wird.

13. Verfahren gemäß einem der Ansprüche 10 bis 12, **dadurch gekennzeichnet, dass** die Simulation (SIMU) der Verbreitung eines elektrischen Stroms in einem erzeugten Modell der Wand des Herzmuskels das Bestimmen wenigstens einer Aktivierung eines Bereichs des Herzmuskels zulässt, der räumlich und/oder zeitlich gegenüber dem Beginn der Aktivierung des als Modell gestalteten Herzmuskels verschoben ist.

14. Verfahren gemäß irgendeinem der Ansprüche 1 bis 5, **dadurch gekennzeichnet, dass** es eine Bestimmung wenigstens eines Isthmus umfasst, der einen elektrischen Gradienten zwischen wenigstens zwei Volumen induziert, wobei die Geometrie des genannten Isthmus durch wenigstens einen Parameter bestimm wird, darunter:
▪ ein bestimmtes Verhältnis zwischen einer Dicke von wenigstens zwei am Isthmus anliegenden Bereichen und einer Dicke des den genannten Isthmus bildenden Bereichs;
▪ eine bestimmte Dicke des den Isthmus bildenden Bereich, **gekennzeichnet durch** eine Mindest-, mittlere oder maximale Beabstandung zwischen zwei Bereichen, die an dem den Isthmus bildenden Bereich anliegen;
▪ eine bestimmte Länge des den Isthmus bildenden Bereichs, der von einer Korridor- oder Kammform gebildet wird, die von der Anordnung der anliegenden Bereiche definiert wird;
▪ eine bestimmte Eingangs- oder Ausgangstopologie des Isthmus, die geeignet ist, Bereiche zu bilden, die deutlich die Trichter- oder Form eines Trichterabschnitts aufweist;
▪ eine lokale Kurve des Isthmus, wie z. B. die Eingangskurve und die Ausgangskurve des Isthmus.

15. Verfahren gemäß Anspruch 14, **dadurch gekennzeichnet, dass** wenigstens einer der Parameter, der die Geometrie eines Bereichs kennzeichnet, die geeignet ist, einen Isthmus zu bilden, mit einem Grenzwert verglichen wird, der das Diskriminieren der Kategorie der Form aus der Gruppe {Isthmus; kein Isthmus} zulässt.

16. Verfahren gemäß irgendeinem der Ansprüche 1 bis 15, **dadurch gekennzeichnet, dass** der Grenzwert von Interesse (Si) 5 mm beträgt und der maximale Grenzwert zwischen 6 mm und 12 mm inbegriffen ist.

17. System, umfassend einen Speicher, der Referenz- und Parametrierungsdaten und einen Rechner umfasst, der zum Realisieren der Schritte des Verfahrens gemäß irgendeinem der Ansprüche 1 bis 6 ausgestaltet ist.

18. System gemäß Anspruch 17, **dadurch gekennzeichnet, dass** es darüber hinaus ein Bildgebungssystem zum Anzeigen einer Simulation einer elektrischen Verbreitung in einem erzeugten Wandmodell umfasst.

19. System gemäß irgendeinem der Ansprüche 17 bis 18, **dadurch gekennzeichnet, dass** es darüber hinaus ein Mittel zum Messen der elektrischen Aktivität des Herzens umfasst, um die Periodizität eines elektrischen Ereignisses mit einer gemessenen Periode eines detektierten einzigartigen elektrischen Schaltkreises zu vergleichen.

## Claims

1. Method of segmentation of a thickness of the myocardium derived from a three-dimensional image for the generation of a model of a myocardial wall in order to detect at least one singular electrical circulation, **characterised in that** it comprises:
• a recording (ACQ) of a three-dimensional image of a wall of the myocardium, said wall delimiting at least one cavity of the heart;
• a segmenting (SEG_1) of a continuous part of the wall (13) into at least one first volume (V1) comprising a thickness less than a first predefined threshold (S1), said first threshold (S1) being less than a threshold of interest (Si) and a second volume (V2) of a continuous part of the wall (13) comprising a thickness greater than a first threshold (S1) and less than the threshold of interest (Si);
• a generation of a model of the wall (MOD_P) of the myocardium in which the continuous part of the wall of the myocardium is modelled (MOD_VOL) according to at least two volumes (V1, V2), said wall model (MOD_P) making it possible to model at least one electrical gradient between said volumes (V1, V2) in order to localise at least one singular zone of electrical circulation.

2. Method according to claim 1, **characterised in that** it comprises:
• a segmentation (SEG_P) prior to the first segmentation (SEG_1) of at least one region of interest (R1) forming a continuous part of the wall of the myocardium (13) and delimited according to a wall thickness criterion, the thickness of the region of interest being less than the maximum thickness threshold (Sₘₐₓ).

3. Method according to any of the preceding claims, **characterised in that** the segmentation (SEG_1) of a part of the wall comprises a segmentation of the volumes into at least three types of thicknesses of which a first thickness (E1) is less than a first predefined threshold (S1), said first threshold (S1) being less than a threshold of interest (Si), a third thickness (E3) is greater than a second predefined threshold (S2), said second threshold (S2) being less than a threshold of interest (Si), and greater than the first threshold (S1), and a second thickness (E2) comprised between the first threshold (S1) and the second threshold (S2), the volumes thereby segmented forming three-dimensional layers of different thicknesses.

4. Method according to claim 3, **characterised in that** the segmentation (SEG_1) of the volumes is carried out according to a plurality of thicknesses (E1, Eₚ₋₁, Eₚ, Eₙ)_{P€[1;N]}, a first thickness (E1) being less than a first predefined threshold (S1), said first threshold (S1) being less than a threshold of interest (Si), a P^{th} thickness (Ep) comprising:
▪ a thickness greater than a (P-1)^{th} predefined threshold, said (P-1)^{th} threshold being less than a threshold of interest (Si), and
▪ a thickness less than a P^{th} predefined threshold, said P^{th} threshold being less than a threshold of interest (Si),
the volumes thereby segmented forming three-dimensional layers of different thicknesses.

5. Method according to any of claims 1 to 4, **characterised in that** each segmented volume comprises dimensions corresponding to a surface representing the surface of a pixel or a voxel and a thickness corresponding to that of the wall at the considered pixel/voxel, the continuous part of the wall corresponding to a set of at least two pixels/voxels forming a continuous portion of the image, the set of segmented volumes of same thickness each forming a three-dimensional layer.

6. Method according to any of claims 1 to 5, **characterised in that** during the segmentation or the generation of the model (MOD_P) of the wall of the myocardium (13), the method comprises an attribution (AT) to each of the segmented volumes of a given value of at least one electrical-physiological parameter.

7. Method according to claim 6, **characterised in that** the segmentation of a part of the wall of the myocardium (13) is carried out jointly with an attribution of values of at least one electrical-physiological parameter, the attribution being carried out according to a function associating with each thickness value a value of an electrical-physiological parameter.

8. Method according to claim 6 or 7, **characterised in that** the attribution of values of at least one electrical-physiological parameter is carried out pixel/voxel by pixel/voxel by considering a continuous part of the wall (13), the wall model (MOD_P) comprising sets of segmented volumes of same thickness and each being associated with a value of at least one electrophysiological parameter, said sets each forming a three-dimensional layer.

9. Method according to one of claims 6 to 8, **characterised in that** at least one electrical-physiological parameter is:
▪ a current propagation speed comprised in the range: [0 m/s; 4 m/s] or;
▪ at least one datum characterising the action potential or;
▪ at least one local electrical impedance or electrical resistance of the modelled wall of the myocardium.

10. Method according to one of claims 6 to 9, **characterised in that** it comprises a step of simulation (SIMU) of the propagation of an electrical current in a generated model of a myocardial wall (MOD_P) making it possible to determine the presence of at least one singular electrical propagation circuit, said singular electrical propagation circuit being a selfsustaining periodic circuit or a circuit comprising two loops.

11. Method according to claim 10, **characterised in that** the electrical simulation includes a determination of the period of a singular electrical propagation circuit thanks to an imaging system.

12. Method according to claim 11, **characterised in that** the determination of the period of a singular electrical propagation circuit includes the detection of a portion of the circuit in which the electrical circulation is slowed down.

13. Method according to one of claims 10 to 12, **characterised in that** the simulation (SIMU) of the propagation of an electrical current in a generated model of a myocardial wall makes it possible to determine at least one activation of a zone of the myocardium shifted spatially and/or temporally vis-à-vis the start of the activation of the modelled myocardium.

14. Method according to any of claims 1 to 5, **characterised in that** it comprises a determination of at least one isthmus inducing an electrical gradient between at least two volumes, the geometry of said isthmus being determined by at least one parameter among which:
▪ A given ratio between a thickness of at least two zones adjacent to the isthmus and a thickness of the zone forming said isthmus;
▪ A given width of the zone forming the isthmus **characterised by** a minimum, average or maximum spacing between two zones adjacent to the zone forming said isthmus;
▪ A given length of the zone forming the isthmus formed by a corridor or peak shape defined by the layout of adjacent zones;
▪ A given inlet or outlet topology of the isthmus liable to form zones having substantially the shape of a funnel or a funnel portion;
▪ A local curvature of the isthmus such as the inlet curvature and the outlet curvature of the isthmus.

15. Method according to claim 14, **characterised in that** at least one of the parameters characterising the geometry of a zone liable to form an isthmus is compared to a threshold value making it possible to discriminate the category of the shape among the group {isthmus; no isthmus}.

16. Method according to any of claims 1 to 15, **characterised in that** the threshold of interest (Si) is 5 mm and that the maximum threshold is comprised between 6 mm and 12 mm.

17. System comprising a memory comprising reference and parameterisation data and a calculator configured to carry out the steps of the method of the invention according to any of claims 1 to 16.

18. System according to claim 17 **characterised in that** it comprises, moreover, an imaging system for visualising a simulation of an electrical propagation in a generated wall model.

19. System according to any of claims 17 to 18, **characterised in that** it comprises, moreover, a means to measure the electrical activity of the heart in order to compare the periodicity of an electrical event with a measured period of a detected singular electrical circuit.
